(19) **Europäisches Patentamt**

**European Patent Office**

**Office européen des brevets**

(11) **EP 0 769 849 B1**

(12) **FASCICULE DE BREVET EUROPEEN**

(45) Date de publication et mention
de la délivrance du brevet:
**06.03.2002 Bulletin 2002/10**

(51) Int Cl.⁷: **H03H 17/06**

(21) Numéro de dépôt: **96402209.9**

(22) Date de dépôt: **16.10.1996**

(54) **Procédé de filtrage numérique large bande et filtre mettant en oeuvre le procédé**

Verfahren zur digitalen Breitbandfilterung und Filter zur Durchführung des Verfahrens

Method for digital wide-band filtering and filter using this method

(84) Etats contractants désignés:
**DE GB IT**

(30) Priorité: **19.10.1995 FR 9512295**

(43) Date de publication de la demande:
**23.04.1997 Bulletin 1997/17**

(73) Titulaire: **ALCATEL**
**75008 Paris (FR)**

(72) Inventeurs:
• **Lesthievent, Chantal**
**31120 Portet/Garonne (FR)**
• **Flament, Claudine**
**31270 Villeneuve-Tolosane (FR)**
• **Oudart, Patrick**
**31270 Cugnaux (FR)**

• **Belis, Eric**
**31600 Toulouse (FR)**

(74) Mandataire: **Smith, Bradford Lee et al**
**COMPAGNIE FINANCIERE ALCATEL Dépt.**
**Propriété Industrielle 30, avenue Kléber**
**75116 Paris (FR)**

(56) Documents cités:
**EP-A- 0 080 712          EP-A- 0 530 468**

• **SMPTE JOURNAL, vol. 100, no. 11, 1 Novembre 1991, pages 869-879, XP000234955 LUTHRA A. ET AL.: "SAMPLING-RATE CONVERSION OF VIDEO SIGNALS"**
• **ELECTRONICS LETTERS, vol. 28, no. 12, 4 Juin 1992, pages 1115-1117, XP000304626 LO K. C. ET AL.: "FAST COMPUTATIONAL ALGORITHM IN PARALLEL RANDOM SAMPLING"**

**Description**

Le domaine de l'invention est celui du traitement numérique du signal et plus particulièrement du filtrage numérique de signaux codés numériquement. Plus précisément, l'invention traite d'une technique de filtrage de signaux à haut débit et\ou à large bande, jusqu'à plusieurs centaines de MHz, et propose une architecture de circuit utilisant cette technique de filtrage, ainsi que son implantation au sein d'un circuit ASIC (Application Specific Integrated Circuit en Anglais).

Le traitement numérique de signal à haut débit et\ou à large bande autorise l'extraction d'une quantité importante d'informations transmises par voie hertzienne sur un canal bruité, par exemple, ou encore le démultiplexage des signaux multiplexés en fréquence (FDM en Anglais) dans des applications de télécommunications. La technique de filtrage numérique de l'invention trouvera également des applications dans des systèmes de réception de signaux radar, par exemple des radars à synthèse d'ouverture, radar Doppler, ou encore pour l'extraction de signatures radar.

Les techniques de la numérisation des signaux et leur traitement numérique autorise une grande flexibilité des systèmes les mettant en oeuvre. En revanche, une limitation de tels systèmes est que le rythme maximal de traitement de données est lié à la fréquence d'échantillonnage des données d'entrée Fe.

Dans les systèmes connus, la fréquence d'échantillonnage peut être augmentée mais au prix d'une augmentation concomitante de la masse, de la consommation, de la complexité et du coût du système, jusqu'à une limite imposée par l'état de l'art de la technologie des composants utilisés. Cette limite paraît infranchissable utilisant les technologies actuelles et les architectures connues.

Un but de l'invention est de s'affranchir des actuelles limites de performances imposées sur les systèmes connus de filtrage numérique, notamment en ce qui concerne la vitesse maximale de traitement.

Plusieurs architectures de filtre numérique sont connues de l'art antérieur. Une discussion sommaire des systèmes connus sera utile à une meilleure compréhension des principes et des avantages de l'invention.

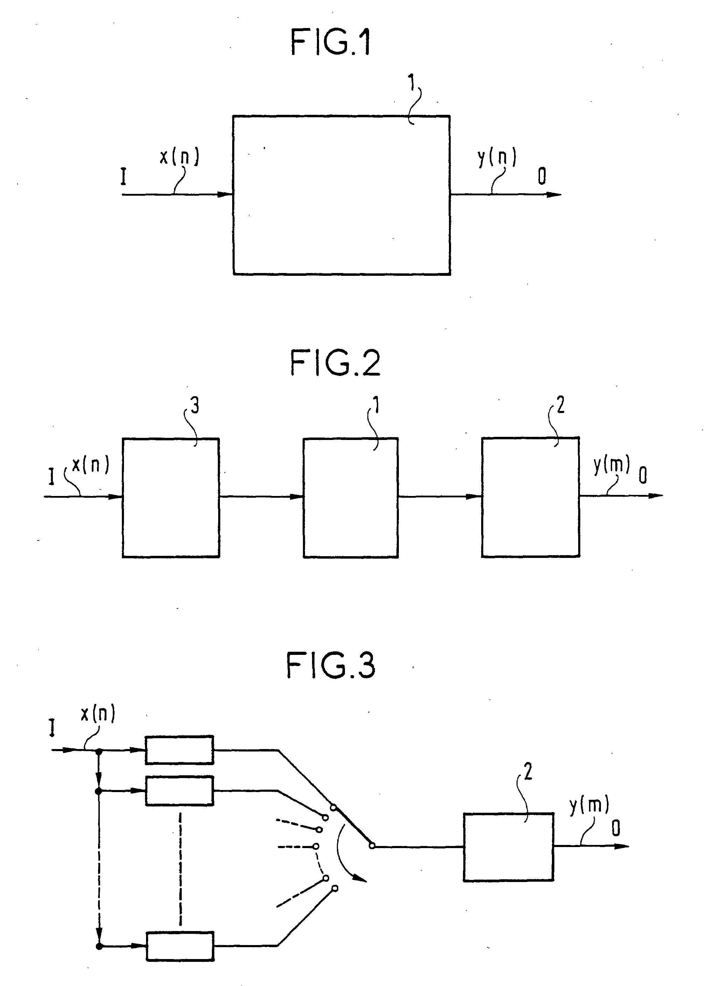

La figure 1 montre une structure classique de filtre numérique, selon laquelle un signal d'entrée x(n) est échantillonné à la fréquence d'échantillonnage Fe, et est appliqué à l'entrée I du filtre 1 caractérisé par sa réponse impulsionnelle échantillonnée qui donne un jeu de coefficients h(n), et le signal filtré y(n) est fourni à la sortie O du filtre 1, échantillonné à la même fréquence Fe :

$$y(n) = \sum_{i=0}^{N-1} h(i) \bullet x(n-i) \quad.$$

Dans cette notation, n représente des incréments de période d'horloge et prend des valeurs entières, qui seront multipliées par une durée de cycle d'horloge inversement proportionnelle à la fréquence d'échantillonnage Fe.

Une application du filtrage numérique consiste à réduire la fréquence d'échantillonnage de sortie Fs à une valeur la plus proche possible de la fréquence de Shannon, i.e. Fs ≈ B si B est la bande du signal. Cette technique est avantageuse pour appliquer un filtrage sur un signal de bande étroite (B) par rapport à la bande d'échantillonnage d'entrée, i.e. Fe > B. Ce rapport de fréquence d'échantillonnage entre le signal d'entrée et le signal de sortie peut s'exprimer dans le cas le plus général par la relation :

$$Fs = \frac{L}{M}Fe, \text{ avec } \frac{L}{M} < 1,$$

L et M entiers.

Les techniques habituellement utilisées pour ce type de traitement combinent une opération d'interpolation 3 suivie d'une opération de décimation 2, tel que présenté sur la figure 2. Le signal d'entrée doit d'abord être interpolé (3) et filtré à la fréquence L*Fe, puis décimé (2) par M afin d'obtenir les données filtrées y(m) en sortie O au rythme d'échantillonnage de sortie Fs. Cette méthode est difficile à mettre en oeuvre, surtout lorsque la fréquence d'échantillonnage Fe est élevée, ou lorsque la valeur de L est grande, entraînant une forte augmentation du rythme de traitement.

Une amélioration connue de ce système peut être obtenue en utilisant une structure polyphase de filtre, pour réaliser la fonction interpolation / filtrage, ce qui permet d'effectuer l'opération de filtrage au rythme de la fréquence d'échantillonnage d'entrée Fe. Une telle structure est présentée sur la figure 3. Pour chaque donnée d'entrée x(n), chacune des L branches $[p_0(n), p_1(n), ... p_{L-1}(n)]$ du réseau polyphasé contribue à la génération d'une des L sorties des L branches, chaque branche fonctionnant ainsi à la fréquence d'échantillonnage d'entrée Fe. La fréquence interpolée L*Fe n'intervient qu'au niveau du multiplexage de sortie des données après filtrage sur les L branches, chaque branche étant donc un sous-filtre $p_\rho(n)$, $\rho$ = 0,1,2,...L-1, correspondant aux versions décimées par L du filtre h(n). Chaque sous-filtre est constitué d'un ensemble de N/L coefficients du filtre h(n).

L'inconvénient majeur de la structure décrite en référence à la figure 3 est qu'elle nécessite l'implantation de L sous filtres $[p_0(n),p_1(n),...p_{L-1}(n)]$, ou phases de filtre global, dont la fréquence de travail est la fréquence d'échantillonnage d'entrée Fe avec un multiplexage des données travaillant à la fréquence interpolée L*Fe. D'autre part, cette structure calcule et délivre un nombre important d'échantillons y(i) qui ne seront pas retenus en sortie, après décimation par M (2). Les données y(m) retenues en sortie O sont délivrées au rythme $Fs = \frac{L}{M}Fe.$

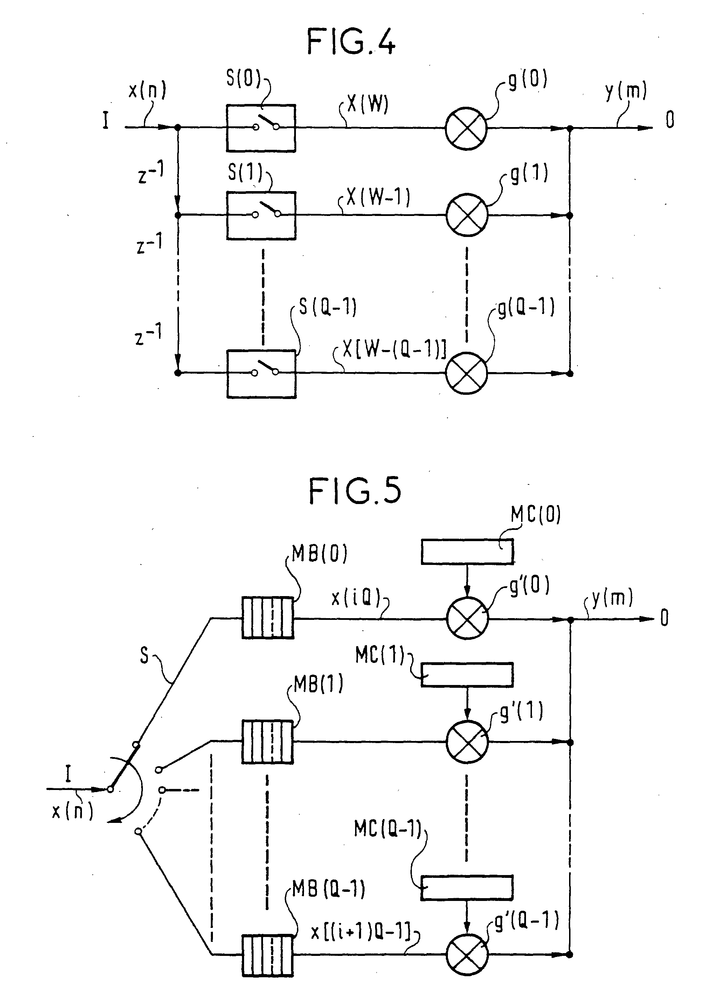

Une autre amélioration du système de la figure 3 consiste à ne calculer que les échantillons retenus en sortie, c'est-à-dire les échantillons utiles y(m). La fréquence de travail des filtres devient alors la fréquence d'échantillonnage de sortie Fs, avec $Fs = \frac{L}{M}Fe$, mais cela impose des modifications au niveau du traitement. En particulier, il est alors nécessaire de re-échantillonner les échantillons d'entrée x(n) et de gérer différemment les coefficients du filtre pour obtenir une structure équivalente à la structure classique. Un tel système est illustré sur la figure 4.

L'architecture du filtre comporte Q étages physiques, avec distribution des données d'entrée x(n) sur tous les étages par l'intermédiaire des registres à décalage, et une sommation des Q étages pour restituer le signal filtré y(m) sur la sortie O. En revanche, les données d'entrée x(n), présentées aux entrées de chaque étage sont sélectionnées par l'intermédiaire d'un réseau d'interrupteurs s(0), s(1), S(Q-1) qui sont activés au rythme de la fréquence de sortie $F_S$. Les échantillons sélectionnés sont ensuite multipliés par les coefficients du filtre.

Pour tenir compte du rapport d'interpolation en $\frac{L}{M}$ la valeur des coefficients appliqués sur chaque étage du filtre est variable dans le temps. Pour qu'une telle architecture fonctionne, il faut choisir le nombre de coefficients N du filtre h(n) comme un multiple du rapport d'interpolation L : N = Q*L. La structure obtenue est une structure de filtre FIR dont les coefficients sont variables dans le temps. Les coefficients appliqués au cours du temps sur chacun des étages du filtre sont $g_{m \oplus L}(0)$, $g_{m \oplus L}(1)$, ... $g_{m \oplus L}(Q-1)$ et les données appliquées à chaque étage sont : x(W), x(W-1), ... x(W-[Q-1]) *avec*

$$W = \left[ \frac{mM}{L} \right] \ ,$$

respectivement.

Les échantillons de sortie y(m) sont ainsi donnés par la relation :

$$y(m) = \sum_{n=0}^{Q-1} g_{m \oplus L}(n) \bullet x(W - n), \ \ avec \ \ W = \left[ \frac{mM}{L} \right] \quad .$$

Cette relation montre que y(m) est la somme pondérée d'une séquence de Q échantillons x(n) démarrant à n = W, c'est-à-dire avec

$$x\left( \frac{mM}{L} \right).$$

Les ensembles de coefficients $g_m$ du filtre varient de façon périodique avec le temps p :

$$g_m(p) = h(pL + mM \oplus L) \ ,$$

où le symbole $\oplus$ désigne l'opération modulo.

Ce système présente toutefois des inconvénients majeurs, liés à la mise en oeuvre de l'échantillonneur bloqueur numérique, et la nécessité de gérer l'asynchronisme entre les fréquences d'échantillonnage Fe et Fs, ainsi que la circulation des données d'entrée x(n) au rythme de la fréquence Fe sur les différentes branches du filtre.

En effet, il est délicat voire impossible lorsque le filtre doit être programmable, de synthétiser une horloge Fs qui soit une valeur fractionnaire exacte de la fréquence de référence Fe. D'autre part, dans le cas où il s'avère nécessaire de re-échantillonner les données d'entrée, il est important d'assurer une parfaite cohérence de phase entre Fe et Fs pour éviter tout glissement éventuel entre les horloges qui aurait pour conséquence de fausser le traitement.

De plus, dans le cas d'une fréquence d'échantillonnage d'entrée Fe élevée, la circulation des données entre les différentes branches du filtre nécessite des technologies rapides qui ne permettent pas toujours de traiter la bande. Ces dernières améliorations imposent bien sûr un coût et une complexité accrus, avec des performances dont la fiabilité n'est pas acquise d'avance. D'autre part, la circulation des données d'entrée entre les Q différentes branches du filtre requiert Q cycles d'horloge Fe, soit (N/M) cycles d'horloge Fs.

Un but de l'invention est un procédé de filtrage numérique pouvant travailler à une fréquence Fs inférieure à la fréquence d'échantillonnage d'entrée Fe sans générer des produits qui ne seront pas retenus en sortie après décimation, et sans recourir à l'utilisation d'un échantillonneur bloqueur numérique.

Il est un autre but de l'invention de proposer un procédé de filtrage numérique ayant une fréquence de traitement et d'échantillonnage de sortie Fs différente de la fréquence d'échantillonnage d'entrée Fe selon lequel le rapport de ces fréquences Fs/Fe peut être arbitraire.

Un autre but de l'invention est un procédé de filtrage numérique selon lequel le rapport temporel de ces fréquences peut être arbitraire et donc asynchrone.

Un autre but de l'invention est de proposer un procédé de filtrage numérique ayant une fréquence d'échantillonnage de sortie Fs inférieure à la fréquence d'échantillonnage d'entrée Fe, sans recourir à la circulation de données entre les différentes branches du filtre. En particulier, selon l'invention, chaque donnée d'entrée sera appliquée à une seule branche du filtre.

A ces fins, l'invention propose un procédé de filtrage numérique comprenant les étapes suivantes :

- les données x(n) du signal d'entrée sont échantillonnées à la fréquence d'échantillonnage d'entrée Fe et sont distribuées et stockées en une pluralité de Q mémoires de type FIFO ou registre de décalage, associées respectivement aux Q branches du filtre ;
- les coefficients de filtrage $g_m(p)$ sont stockés dans au moins une autre mémoire dite de coefficients ;
- une interpolation par L sur chaque branche ;
- les multiplications des données x(n) par les coefficients $g_m(p)$ sont effectuées à la cadence Fs ;
- suivie d'une décimation par M, permettant d'abaisser la fréquence de travail du filtre à la fréquence de sortie *Fs* $= \frac{L}{M}Fe,$ avec L, M entiers et $\frac{L}{M} < 1.$

Selon une caractéristique importante de l'invention, les données x(n) sur chaque branche restent présentes pendant plusieurs multiplications, $\approx \frac{Fe}{Q}$, et la rotation de coefficients sur chaque branche est obtenue par une incrémentation d'adresse dans ladite mémoire coefficients à chaque période d'horloge.

Selon une variante, le procédé de l'invention peut être mis en oeuvre dans une architecture parallèle, comprenant une pluralité de filtres qui fonctionnent selon les principes énumérés ci-dessus, avec un séquencement synchrone entre les filtres parallèles.

Selon une autre variante, plusieurs filtres parallèles selon l'une quelconque des réalisations précédentes peuvent être mis en cascade.

L'invention propose également des architectures de circuits pour la mise en oeuvre du procédé selon l'invention.

D'autres caractéristiques et avantages de l'invention apparaîtront à la lecture de la description détaillée de quelques exemples de réalisations qui sera faite ci-après, avec ses dessins annexés, dont :

- la figure 1, déjà décrite, qui montre schématiquement en bloc diagramme, un filtre numérique classique de l'art antérieur ;
- la figure 2, déjà décrite, qui montre schématiquement en bloc diagramme, un autre exemple d'un filtre numérique classique de l'art antérieur, avec une interpolation suivie d'une décimation ;
- la figure 3, déjà décrite, qui montre schématiquement en bloc diagramme, un autre exemple d'un filtre numérique interpolateur de l'art antérieur, avec L sous filtres travaillant à Fe, suivi d'un multiplexage et d'une décimation ;
- la figure 4, déjà décrite, qui montre schématiquement en bloc diagramme, un autre exemple d'un filtre numérique de l'art antérieur, avec Q étages travaillant à Fe, alimentés par une circulation de données d'entrée à l'aide d'un échantillonneur bloqueur, suivi d'un multiplexage ;
- La figure 5, qui montre schématiquement et en bloc diagramme, un filtre selon l'invention, à changement de rythme et à données distribuées par branche, avec circulation de coefficients ;
- la figure 6, qui montre schématiquement un exemple de principe de traitement de filtrage selon l'invention, avec réduction du rythme d'échantillonnage dans un rapport 3/5, avec Q = 4 branches, et N = 12 coefficients ;
- la figure 7, qui montre schématiquement et en plan, un exemple selon l'invention d'un circuit intégré comportant deux filtres cascadés de quatre branches chacun ;

- la figure 8, qui montre schématiquement et en perspective, une parallélisation de P filtres selon la figure 5 ;
- la figure 9, qui montre schématiquement et en bloc diagramme, une cascade de filtres parallèles selon la figure précédente.

Sur toutes les figures, données à titre d'exemples non limitatifs de quelques exemples de réalisations selon l'invention ou de ses principales variantes, les mêmes repères se réfèrent aux mêmes éléments, et l'échelle n'est pas toujours respectée pour des raisons de clarté.

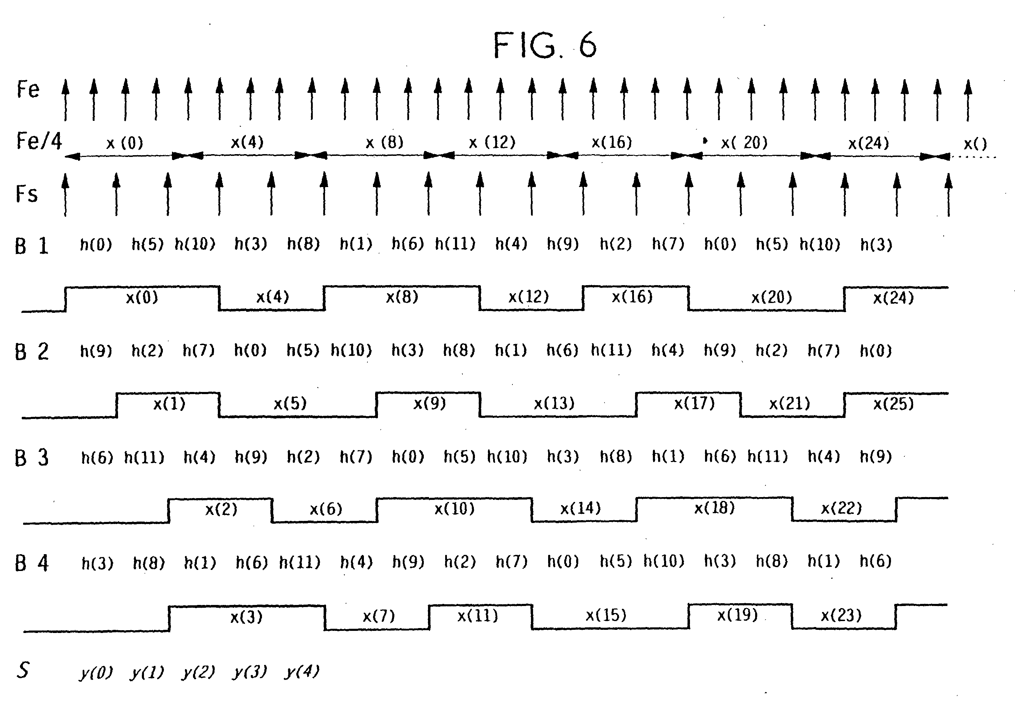

Sur la figure 5, on voit schématiquement et en bloc diagramme, un filtre selon l'invention, à changement de rythme et à données distribuées par branche, avec circulation de coefficients. Cette figure aidera à la compréhension du procédé selon l'invention.

Les données échantillonnées x(n) arrivent sur l'entrée I du filtre au rythme d'échantillonnage d'entrée Fe et sont distribuées à l'aide d'un démultiplexeur ou commutateur S, au fur et mesure de leur arrivée, sur les Q branches du filtre où elles sont stockées dans Q mémoires tampon de type FIFO ou des registres de décalage MB(0), MB(1), ... MB(Q-1).

Dans le deuxième cas la mémoire doit obligatoirement être associée à des registres associés à chacune des branches.

Les coefficients de filtrage g'(0), g'(1), ... g'(Q-1) sont également stockés dans des mémoires coefficients MC(1), MC(2), ... MC(Q-1) qui peuvent être des mémoires distinctes ou simplement des zones mémoire dans une mémoire suffisamment grande.

Les multiplications sont cadencées au rythme $\frac{L}{M} Fe$ , et à chaque période de cette horloge les coefficients du filtre sont modifiés par re-adressage de la mémoire coefficient. En revanche, les données d'entrée sont quasi stables et restent présentes pendant toute la période d'horloge $\frac{Fe}{Q}$ sur la même branche du filtre. Quand toutes les multiplications nécessaires sur une donnée ont été effectuées, après une période de

$$ INT \left( \frac{N}{M} Fs \right) \approx \frac{Fe}{Q} \, , $$

les données d'entrée sont réactualisées. Cette pseudo stabilité des données par rapport aux branches du filtre est compensée par la circulation des jeux de coefficients par branche.

On peut donner des règles qui permettent de savoir quels coefficients et quelles données seront adressées pour être multipliés à un instant donné. Utilisant la notation $N = Q \cdot L$, i.e. le nombre de coefficients N du filtre h(n) est un multiple du rapport d'interpolation L, l'association d'une donnée à une seule branche du filtre revient à mettre en place un traitement où une même donnée x(n) interviendra N/M fois (en fait, c'est l'une des valeurs entières encadrant N/M). En revanche, la valeur de chaque coefficient appliqué à une donnée x(n) change avec chaque cycle d'horloge Fs.

Sur une même branche, l'indice du coefficient appliqué à chaque période d'horloge Fs peut être calculé à l'aide de la formule suivante :

$$ i_Q(n+1) = i_Q (n) + M \oplus N \, . $$

D'une branche à l'autre, l'indice appliqué à un moment donné n est décrémenté de L :

$$ i_Q (n) = i_{Q-1}(n) - L \oplus N \, . $$

En utilisant les relations ci-dessus, on montre que la séquence des indices sur une même branche a une longueur finie quelles que soient les valeurs de L et de M, et que cette longueur est inférieure ou égale à N . Cela veut dire qu'une nouvelle donnée x(n) est appliquée à chaque fois que dans le calcul d'indice du coefficient on dépasse la valeur de N, et ceci correspond à l'application d'un nouveau sous-ensemble de coefficients $g_m$ du filtre h(n) à la donnée x(n+Q).

Le procédé de l'invention présente, entre autre, les deux avantages majeurs suivants :

1) - une totale indépendance entre les horloges d'échantillonnage d'entrée Fe et de sortie Fs ;
2) - pas de circulation de données entre les différentes branches du filtre .

Chaque donnée d'entrée est appliquée à une seule branche du filtre, au fur et à mesure de son arrivée. La mémoire FIFO ou registre à décalage associée à chaque branche du filtre permet de libérer le filtre des contraintes de synchronisme entre les horloges d'échantillonnage d'entrée Fe et de sortie Fs qui existaient dans les filtres de l'art antérieur. La prise en compte des données d'entrée x(n) est gérée par le filtre lui-même, ainsi que la sélection des données pour le besoin du traitement. La fréquence de traitement et de l'horloge des opérations internes du filtre est la fréquence de sortie Fs.

La figure 6 montre schématiquement un exemple de principe de traitement de filtrage selon l'invention, avec réduction du rythme d'échantillonnage dans un rapport 3/5, avec Q = 4 branches, et N = 12 coefficients, et permet de mieux comprendre l'explication que l'on vient de donner à l'aide de la figure 5. La période moyenne d'utilisation d'une même donnée est de N/M = 12/5 soit 2 ou 3 périodes de Fs.

Sur cette figure 6, on voit un exemple d'un jeu de chronogrammes qui montre la relation temporelle entre les différentes opérations qui sont effectuées lors du fonctionnement d'un filtre numérique selon le procédé de l'invention. Sur le premier chronogramme en haut, on voit une succession de tops d'horloge à la fréquence d'échantillonnage d'entrée Fe. A chaque top d'horloge, une donnée d'entrée x(n) échantillonnée et distribuée sur l'une des Q branches du filtre, où elle sera stockée dans une mémoire tampon ou registre de décalage MB(0), ... MB(Q-1).

Une donnée x(n) reste disponible sur une branche pendant une période de $\frac{Fe}{Q}$. Ceci est montré sur le deuxième chronogramme pour Q = 4 branches. La première donnée x(0) reste sur la première branche pendant $\frac{Fe}{Q}=\frac{Fe}{4}$. Après Q = 4 périodes d'horloge Fe, la donnée suivante x(4) est mise à disposition sur la première branche par le registre à décalage MB(0), et ceci pendant 4 périodes d'horloge, et ainsi de suite. Les données entre x(0) et x(4) ont été distribuées sur les autres Q-1 = 3 branches du filtre, où un chronogramme similaire régit leur utilisation en succession.

Le chronogramme suivant montre la fréquence de sortie Fs qui est réduite dans une proportion de 3/5 par rapport à Fe. C'est à cette fréquence de sortie Fs que seront effectuées toutes les multiplications du filtre, tel que montré sur les chronogrammes suivants.

Les quatre chronogrammes suivants montrent le déroulement des multiplications sur les quatre branches B1, B2, B3, B4 du filtre, indiquées par la présence simultanée d'un coefficient h(n) et une donnée d'entrée x(n) à un moment n. On voit par exemple pour la première branche B1 que les coefficients h(0), h(5), h(10), h(3), ... sont fournis en succession, par adressage de la mémoire coefficients, au rythme d'horloge de la fréquence de sortie Fs. La première donnée x(0) reste pendant quatre périodes d'horloge de la fréquence d'entrée Fe, ce qui correspond aux trois premières multiplications, c'est-à-dire par h(0), h(5), h(10). La deuxième donnée x(4) reste disponible pendant quatre périodes d'horloge de la fréquence d'entrée Fe, ce qui correspond aux deux prochaines multiplications, à la fréquence de sortie, c'est-à-dire par h(3), h(8).

On voit sur ces chronogrammes l'illustration visuelle des règles énoncées ci-dessus pour la distribution des données d'entrée sur les branches du filtre au rythme de la fréquence d'entrée Fe, la circulation des coefficients au rythme de la fréquence de sortie Fs, le décalage des données dans les registres à décalage, les multiplications au rythme de la fréquence de sortie Fs, et enfin, les données filtrées de sortie y(0), y(1), y(2), ... qui sont fournies au rythme de la fréquence de sortie Fs.

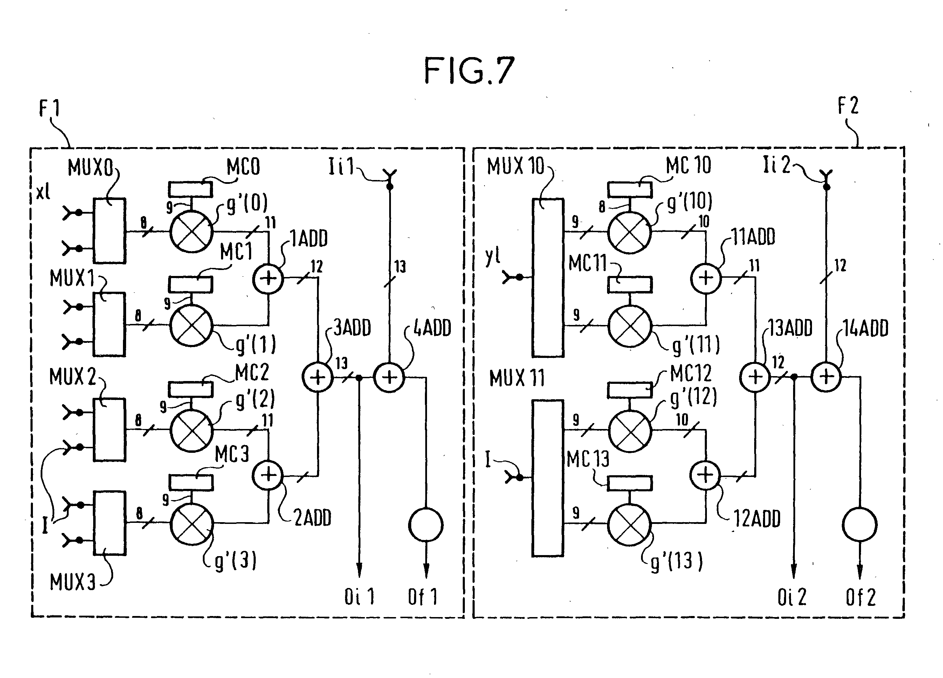

La figure 7 montre schématiquement et en plan, un exemple selon l'invention d'un circuit intégré comportant deux filtres F1, F2 cascadés de quatre branches chacun. Le circuit montré a été réalisé en technologie CMOS sur un circuit ASIC de 30 000 portes, et a été conçu de manière à pouvoir être cascadé et parallélisé par quatre. Une parallélisation de ce circuit permet par exemple de traiter un signal de 70 MHz de bande échantillonnée à la fréquence de 250 MHz.

On voit à gauche l'entrée I du premier filtre F1, qui consiste en un premier banc de multiplexeurs MUX0, MUX1, MUX2, MUX3, les données d'entrée sont échantillonnées sur 8 bits. Les mémoires tampons sont en amont et ne sont pas montrées sur ce circuit. Pour chaque liaison sur le circuit, le nombre de bits de codage est indiqué. Les MUX sont reliés par des liaisons 8 bits à des multiplieurs g' (0), g' (1), g' (2), g' (3). La deuxième entrée des multiplieurs est reliée à des mémoires RAM coefficients MC0, MC1, MC2, MC3 par des liaisons 9 bits. Les produits à la sortie des multiplieurs sont codés sur 11 bits. Trois étages d'additionneurs (1ADD, 2ADD, 3ADD) permettent de sommer huit étages du premier filtre (quatre étages dudit ASIC plus quatre étages supplémentaires provenant d'un ASIC associé).

La sortie de l'étage F1 est donc fournie sur une sortie de calcul intermédiaire Oil, en amont d'un dernier additionneur 4ADD qui permet d'ajouter, par une entrée de calcul intermédiaire Ii1, les produits de filtrage provenant d'autres étages de filtre (non montrées, 13 bits) aux produits (13 bits) du présent étage F1. Le résultat final sur la sortie finale est obtenue Of1 est obtenu après arrondi à 9 bits.

On voit à gauche l'entrée I du deuxième filtre F2, qui consiste en un premier banc de multiplexeurs MUX10, MUX11, avec des entrées à 9 bits, issus de l'étage précédent F1. Les MUX sont reliés par des liaisons 9 bits à des multiplieurs g' (10), g' (11), g'(12), g'(13). Ces multiplieurs sont également raccordés par leurs entrées respectives à des mémoires RAM des coefficients MC10, MC11, MC12, MC13 par des liaisons 8 bits. Les produits à la sortie des multiplieurs sont fournis sur des liaisons 10 bits et additionnées (11ADD, 12ADD, 13ADD) de la même manière que pour le filtre F1. Le codage du calcul intermédiaire est effectué sur 12 bits.

La sortie de l'étage F2 est fournie sur une sortie de calcul intermédiaire Oi2, en amont d'un dernier additionneur 14ADD qui permet d'ajouter, par une entrée de calcul intermédiaire Ii2, les produits de filtrage provenant d'autres étages de filtre (non montrées, 12 bits) aux produits (12 bits) du présent étage F2. Le résultat final sur la sortie finale Of2 est obtenu après arrondi à 8 bits.

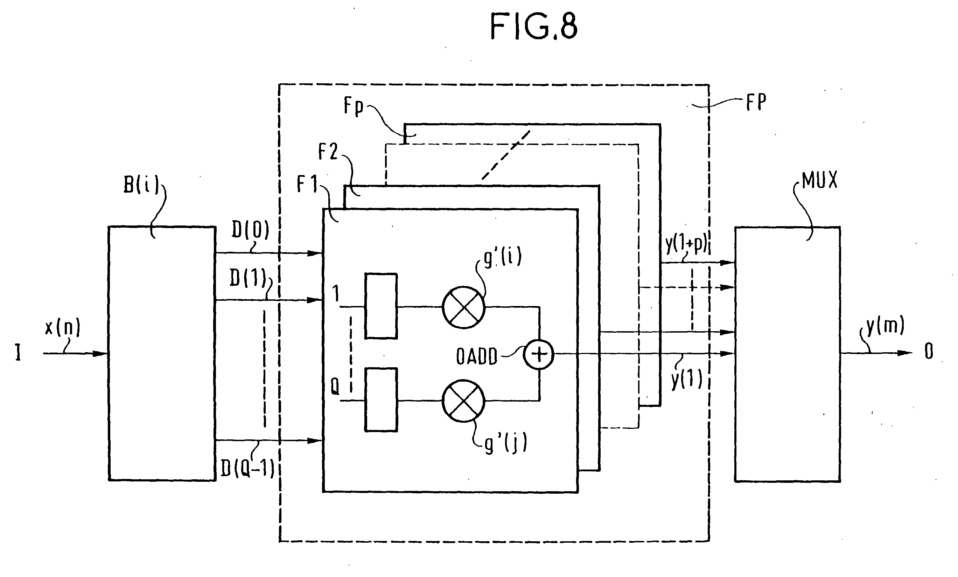

Les entrées et sorties intermédiaires présentées sur ce circuit permettent sa parallélisation de manière facile. La figure 8 montre schématiquement et en perspective une telle parallélisation de P filtres selon la figure 5. En amont du filtre parallèle FP, l'entrée I des données x(n) échantillonnées à la fréquence d'échantillonnage d'entrée Fe est raccordée à une mémoire tampon B(i), qui, dans l'exemple de la figure 8, est une mémoire suffisamment grande pour servir toutes les branches de tous les plans du filtre parallèle FP. Les données sont fournies par cette mémoire tampon B(i) via des liaisons D(0), D(1), ... D(Q-1) aux Q entrées des Q branches de chaque plan selon les mêmes règles que dans les exemples donnés ci-dessus, à l'exception près de diviser la fréquence de traitement par le nombre p des plans du filtre parallèle FP : $Fs = Fe\frac{L}{PM}$.

Pour optimiser la vitesse de traitement à la bande B à traiter, il est avantageux de sélectionner un degré de parallélisation P qui soit un sous multiple du nombre de branches du filtre, ce qui simplifie la distribution des coefficients entre les différents plans de parallélisation. Cette architecture parallèle est totalement synchrone.

Sur cette figure 8, le premier plan F1 montre très schématiquement un filtre conforme au filtre montré sur la figure 7, dont la description ne sera pas répétée. Tous les autres plans F2, ... Fp sont similaires et ne seront pas décrits plus en détail. Chaque plan F1, F2, ... Fp fournit une sortie y(1), y(2), y(3), ... y(1+p) associées aux p entrées respectives d'un multiplexeur MUX externe au filtre, qui fournit à sa sortie les données filtrées y(m) au rythme de la fréquence sortie $Fs = Fe\frac{L}{M}$.

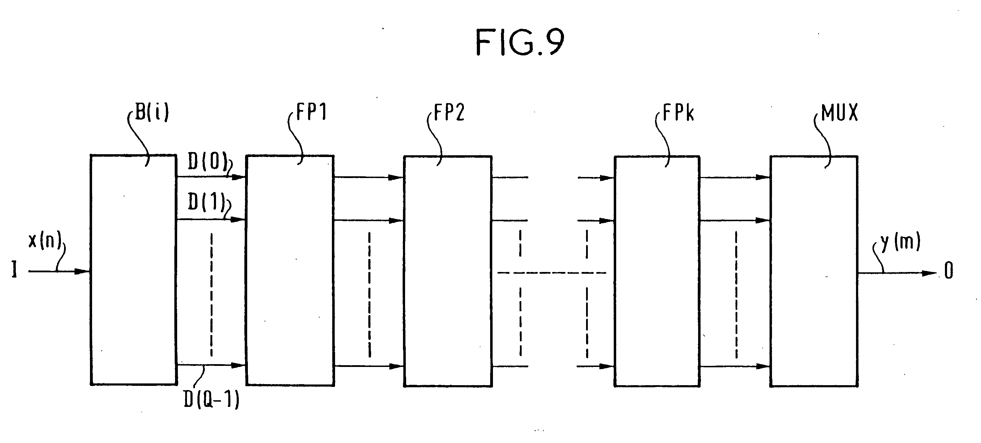

La figure 9 montre schématiquement et en bloc diagramme, une cascade de filtres parallèles selon la figure précédente. En amont du premier filtre parallèle FP1, l'entrée I des données x(n) échantillonnées à la fréquence d'échantillonnage d'entrée Fe est raccordée à une mémoire tampon B(i), qui, comme dans l'exemple de la figure 8, est une mémoire suffisamment grande pour servir toutes les branches de tous les plans du filtre parallèle FP1. Les données sont fournies par cette mémoire tampon B(i) via des liaisons D(0), D(1), ... D(Q-1) aux Q entrées des Q branches de chaque plan selon les mêmes règles que dans la figure 8. La fréquence de traitement est la même que dans la figure 8 : $Fs = Fe\frac{L}{PM}$.

Les p sorties parallèles des données y(1), y(2), ... y(1+p) sont raccordées directement aux p entrées de l'étage suivant FP2, et ainsi de suite. Au total, k filtres parallèles FP1, FP2, ... FPk sont cascadés de cette manière. A la fin de la chaîne, les p sorties du dernier filtre FPk sont multiplexées MUX pour fournir les données filtrées y(m) au rythme de la fréquence de sortie $Fs = Fe\frac{L}{M}$.

En effet, des études nous ont montré qu'il est possible d'optimiser le nombre des coefficients nécessaires pour des caractéristiques de filtrage données, en cascadant plusieurs filtres parallèles. L'intérêt de cette structure en cascade réside bien évidemment dans l'adaptation du nombre des entrées d'un filtre au nombre de sorties du filtre précédent, tel que l'on vient de décrire.

Enfin, l'avantage d'un fonctionnement synchrone est conservé. Il suffit de retenir comme fréquence de travail des filtres la fréquence des sorties du premier filtre $Fs = Fe\frac{L_1}{M_1}$.

La fréquence de sortie des filtres cascadés sera construite en utilisant la technique de viols de cycles. Cette technique permet de conserver le traitement synchrone. Les séquences des coefficients des filtres seront construites en tenant compte de ces temps morts. De même les échantillons de sortie valides seront repérés par un signal de validation.

**Revendications**

**1.** procédé de filtrage numérique comprenant les étapes suivantes :

- les données x(n) du signal d'entrée sont échantillonnées à la fréquence d'échantillonnage d'entrée Fe et sont distribuées et stockées en une pluralité de Q mémoires de type FIFO ou registre de décalage, associées respectivement aux Q branches du filtre ;
- les coefficients de filtrage $g_m(p)$ sont stockés dans au moins une autre mémoire dite de coefficients ;
- une interpolation par L sur chaque branche ;
- les multiplications des données x(n) par les coefficients $g_m(p)$ sont effectuées à la cadence de la fréquence de sortie Fs ;
- suivie d'une décimation par M, permettant d'abaisser la fréquence du travail du filtre à la fréquence de sortie $Fs = \frac{L}{M}Fe$, avec L, M entiers et $\frac{L}{M} < 1$.

**2.** Procédé selon la revendication 1, **caractérisé en ce que** les données x(n) sur chaque branche restent présentes pendant plusieurs multiplications, $\approx \frac{Fe}{Q}$, et la rotation de coefficients sur chaque branche est obtenue par la permutation d'adresses dans ladite mémoire coefficients à chaque période d'horloge.

3. Procédé selon l'une quelconque des revendications 1 ou 2, **caractérisé en ce que** lesdites multiplications sont effectuées en parallèle sur une pluralité p de plans de filtres (F1, F2, ...Fp), chaque plan de filtre comportant Q branches, lesdits p plans de filtre étant raccordés dans une architecture parallèle, permettant d'abaisser la fréquence du travail du filtre à la fréquence de sortie $Fs = \frac{L}{pM}Fe$, avec un séquencement synchrone entre les filtres parallèles.

4. Procédé selon la revendication 3, **caractérisé en ce que** lesdites multiplications sont effectuées en cascade par une pluralité k de filtres parallèles (FP1, FP2, ...FPk), chaque filtre parallèle comportant p plans, lesdits filtres parallèles étant raccordés en séries, les p sorties de chaque filtre parallèle précédent étant raccordées aux p entrées du filtre parallèle suivant en cascade.

5. Architecture de filtre numérique comprenant

- des moyens de distribution de données échantillonnées d'entrée x(n) ;
- des moyens de stockage temporaire desdites données d'entrée x(n) qui sont par exemple une pluralité de Q mémoires de type FIFO ou registre de décalage ;
- Q branches du filtre ;
- au moins une autre mémoire dite de coefficients pour le stockage de coefficients de filtrage $g_m(p)$ ;
- des moyens de multiplication des données x(n) par les coefficients $g_m(p)$ ;
- des moyens d'interpolation par L ;
- des moyens de décimation par M, avec L, M entiers et $\frac{L}{M} < 1$ ;

lesdits moyens de stockage temporaire desdites données d'entrée étant associés respectivement aux dites Q branches dudit filtre pour fournir lesdites données auxdits moyens de multiplication ;
ledit au moins un mémoire de coefficients étant raccordé auxdits moyens de multiplication afin de fournir lesdits coefficients auxdits moyens de multiplication ;
lesdits moyens de multiplication fournissant en sortie des données filtrées y(m).

6. Architecture parallèle de filtre numérique comportant une pluralité de filtres selon la revendication 5 raccordés en parallèle.

7. Architecture cascadée de filtre numérique comportant une pluralité de filtres selon l'une quelconque des revendications 5 ou 6.

8. Circuit de filtre numérique selon l'une quelconque des architectures des revendications 5 à 7 pour la mise en oeuvre d'un procédé selon l'une quelconque des revendications 1 à 4.

**Patentansprüche**

1. Verfahren zur digitalen Filterung mit den folgenden Schritten:

- die Daten x(n) des Eingangssignals werden mit der Eingangs-Abtastfrequenz Fe abgetastet und auf eine Mehrzahl von Q Speichern vom FIFO- oder Schieberegistertyp verteilt und gespeichert, die jeweils den Q Zweigen des Filters zugeordnet sind;
- die Filterungskoeffizienten $g_m(p)$ werden in wenigstens einem anderen Speicher, als Koeffizientenspeicher bezeichnet, gespeichert;
- eine L-fache Interpolation auf jedem Zweig;
- die Multiplikationen der Daten x(n) mit den Koeffizienten $g_m(p)$ werden im Takt der Ausgangsfrequenz Fs durchgeführt;
- anschließend eine Dezimierung um M, die es ermöglicht, die Arbeitsfrequenz des Filters auf die Ausgangsfrequenz Fs=(L/M)Fe zu verringern, wobei L, M ganze Zahlen sind und L/M <1 ist.

2. Verfahren nach Anspruch 1, **dadurch gekennzeichnet, dass** die Daten x(n) auf jedem Zweig während einer Mehrzahl $\approx$ Fe/Q von Multiplikationen vorhanden bleiben und die Rotation der Koeffizienten auf jedem Zweig erreicht wird durch Permutation von Adressen in dem Koeffizientenspeicher in jeder Taktperiode.

**3.** Verfahren nach einem beliebigen der Ansprüche 1 oder 2, **dadurch gekennzeichnet, dass** die Multiplikationen parallel auf einer Mehrzahl p von Filterebenen (F1, F2, ... Fp) durchgeführt werden, wobei jede Filterebene Q Zweige umfasst und die p Filterebenen in einer Parallelarchitektur verbunden sind, was es ermöglicht, die Arbeitsfrequenz des Filters auf die Ausgangsfrequenz Fs=(L/pM) Fe abzusenken, mit einer synchronen Sequenzierung zwischen den parallelen Filtern.

**4.** Verfahren nach Anspruch 3, **dadurch gekennzeichnet, dass** die Multiplikationen in einer Kaskade durch eine Mehrzahl k von parallelen Filtern (FP1, FP2, ..., Fk) durchgeführt werden, wobei jedes parallele Filter p Ebenen umfasst und die parallelen Filter in Reihe verbunden sind, und die p Ausgänge jedes vorhergehenden parallelen Filters mit den p Eingängen des in der Kaskade nachfolgenden parallelen Filters verbunden sind.

**5.** Digitale Filterarchitektur mit:

- Mitteln zum Verteilen von abgetasteten Eingangsdaten x(n);
- Mitteln zum zeitweiligen Speichern der Eingangsdaten x(n), welche z.B. eine Mehrzahl von Q speichern vom FIFO- oder Schieberegistertyp sind;
- Q Zweigen des Filters;
- wenigstens einem anderen Speicher, als Koeffizientenspeicher bezeichnet, zum Speichern der Filterungskoeffizienten $g_m(p)$;
- Mitteln zum Multiplizieren der Daten x(n) mit den Koeffizienten $g_m(p)$;
- Mitteln zum L-fach-Interpolieren;
- Mitteln zum Dezimieren um M, wobei L, M ganze Zahlen sind und L/M <1 ist;
- wobei die Mittel zum zeitweiligen Speichern der Eingangsdaten jeweils den Q Zweigen des Filters zugeordnet sind, um die Daten an die Mittel zum Multiplizieren zu liefern;
- der wenigstens eine Koeffizientenspeicher an die Mittel zum Multiplizieren angeschlossen ist, um die Koeffizienten an die Mittel zum Multiplizieren zu liefern;
- die Mittel zum Multiplizieren am Ausgang gefilterte Daten y(m) liefern.

**6.** Parallele digitale Filterarchitektur mit einer Mehrzahl von parallel geschalteten Filtern nach Anspruch 5.

**7.** Kaskadierte digitale Filterarchitektur mit einer Mehrzahl von Filtern nach einem beliebigen der Ansprüche 5 oder 6.

**8.** Digitale Filterschaltung nach einer beliebigen der Architekturen der Ansprüche 5 bis 7 zur Durchführung eines Verfahrens nach einem beliebigen der Ansprüche 1 bis 4.

**Claims**

**1.** A digital filter method comprising the following steps:

· input signal data x(n) is sampled at the input sampling frequency Fe and is shared between and stored in a plurality of Q memories of shift register or FIFO type, respectively associated with the Q branches of the filter;
· the filter coefficients $g_m(p)$ are stored in at least one other memory referred to as a "coefficient" memory;
· interpolation by L is performed on each branch;
· data samples x(n) are multiplied by the coefficients $g_m(p)$ at the rate of the output frequency Fs; and
· there follows decimation by M, enabling the working frequency of the filter to be lowered to the output frequency Fs = (L/M)Fe, where L and M are integers and L/M < 1.

**2.** A method according to claim 1, **characterized in that** the data samples x(n) in each branch remain present for a plurality ≈ Fe/Q of multiplications and coefficients are rotated in each branch by permutation of addresses in said coefficient memory at each clock period.

**3.** A method according to claim 1 or 2, **characterized in that** said multiplications are performed in parallel on a plurality p of filter planes (F1, F2, ..., Fp), each filter plane having Q branches, said p filter planes being connected in a parallel architecture, thereby enabling the working frequency of the filter to be lowered to the output frequency Fs = (L/pM)Fe with synchronous sequencing between the parallel filters.

**4.** A method according to claim 3, **characterized in that** said multiplications are formed in cascade by a plurality k of parallel filters (FP1, FP2, ..., FPk), each parallel filter comprising $\underline{p}$ planes, said parallel filters being connected in series, the $\underline{p}$ outputs from each preceding parallel filter being connected to the $\underline{p}$ inputs of each following parallel filter in the cascade.

**5.** Digital filter architecture comprising:

· means for sharing input sampled data x(n);
· means for temporary storage of said input data x(n), e.g. a plurality Q of memories of shift register or FIFO type;
· Q branches of the filter;
· at least one other memory referred to as a "coefficient" memory for storing filter coefficients $g_m(p)$;
· means for multiplying data x(n) by the coefficients $g_m(p)$;
· means for performing interpolation by L;
· means for decimation by L, with integer L and M and with L/M < 1;
said temporary storage means for said input data being associated respectively with said Q branches of said filter to provide said data to said multiplication means;
said at least one coefficient memory being connected to said multiplication means to supply said coefficients to said multiplication means; and
said multiplication means outputting filtered data y(m).

**6.** Parallel digital filter architecture comprising a plurality of filters according to claim 5 connected in parallel.

**7.** Cascaded digital filter architecture comprising a plurality of filters according to claim 5 or 6.

**8.** A digital filter circuit according to the architecture of any one of claims 5 to 7 for implementing a method according to any one of claims 1 to 4.

# FIG.1

# FIG.2

# FIG.3

# FIG.4

# FIG.5

# FIG. 6

Fe ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑

Fe/4   x(0)   x(4)   x(8)   x(12)   x(16)   x(20)   x(24)   x()

Fs ↑ ↑ ↑ ↑ ↑ ↑ ↑ ↑ ↑ ↑ ↑ ↑ ↑ ↑ ↑ ↑

B1   h(0) h(5) h(10) h(3) h(8) h(1) h(6) h(11) h(4) h(9) h(2) h(7) h(0) h(5) h(10) h(3)

x(0)   x(4)   x(8)   x(12)   x(16)   x(20)   x(24)

B2   h(9) h(2) h(7) h(0) h(5) h(10) h(3) h(8) h(1) h(6) h(11) h(4) h(9) h(2) h(7) h(0)

x(1)   x(5)   x(9)   x(13)   x(17)   x(21)   x(25)

B3   h(6) h(11) h(4) h(9) h(2) h(7) h(0) h(5) h(10) h(3) h(8) h(1) h(6) h(11) h(4) h(9)

x(2)   x(6)   x(10)   x(14)   x(18)   x(22)

B4   h(3) h(8) h(1) h(6) h(11) h(4) h(9) h(2) h(7) h(0) h(5) h(10) h(3) h(8) h(1) h(6)

x(3)   x(7)   x(11)   x(15)   x(19)   x(23)

S   y(0) y(1) y(2) y(3) y(4)

EP 0 769 849 B1

FIG.7

FIG.8

FIG.9

EP 0 769 849 B1